## Europäisches Patentamt
## European Patent Office
## Office européen des brevets

(11) Publication number: **0 079 356**
**B1**

# EUROPEAN PATENT SPECIFICATION

(45) Date of publication of patent specification: **12.03.86**

(51) Int. Cl.⁴: **C 23 G 1/02**

(21) Application number: **82901553.6**

(22) Date of filing: **06.05.82**

(86) International application number:
**PCT/SE82/00154**

(87) International publication number:
**WO 82/04072 25.11.82 Gazette 82/28**

(54) **A METHOD FOR CHEMICALLY STRIPPING PLATINGS INCLUDING PALLADIUM AND AT LEAST ONE OF THE METALS COPPER AND NICKEL AND A BATH INTENDED TO BE USED FOR THE METHOD.**

(30) Priority: **21.05.81 SE 8103205**

(43) Date of publication of application:
**25.05.83 Bulletin 83/21**

(45) Publication of the grant of the patent:
**12.03.86 Bulletin 86/11**

(84) Designated Contracting States:
**AT BE CH DE FR GB LI NL**

(56) References cited:
**DE-A-2 532 773**

(73) Proprietor: **TELEFONAKTIEBOLAGET L M ERICSSON**
**S-126 25 Stockholm (SE)**

(72) Inventor: **SKOWRONEK, Jerzy**
**Boktryckargatan 35**
**S-602 23 Norköping (SE)**
Inventor: **PERSSON, Jan Ola**
**Trestegsgatan 59**
**S-603 63 Norrköping (SE)**

(74) Representative: **Johnsson, Helge et al**
**Telefonaktiebolaget L M Ericsson**
**S-126 25 Stockholm (SE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Technical field

The invention relates to a method for chemically stripping platings including palladium and at least one of the metals copper and nickel, especially from racks used for combined electroless and electrolytic metallizing of objects. Furthermore, the invention relates to a bath intended to be used for the method.

Background art

Combined electroless and electrolytic metallizing is used in a large extent to coat insulated objects with a metallic plating. The usual procedure is to initially coat the surface of the insulated object with an activator, in general palladium, which functions as a catalyst when the object in a following step is submerged into a electroless metallizing bath. Due to the disadvantages which are often associated with electroless metallizing baths such as low plating rate and low stability, normally a thin plating is made by this method. This plating is connected to a current source and the plating is built up to the desired thickness in a galvanic bath. Examples are the production of printed circuits with plated-through holes and coating plastic objects with a nickel plating.

When metallizing according to the described procedure the objects which are to be metallized are mounted in racks installed on a conveyor. These racks are transferred from one bath to another in a sequence determined by the used metallizing process. An example of the sequence in producing printed circuit cards with plated through-holes is as follows: degreasing — pre-etching — preactivation — activation—development of activator—electroless copper plating. After these steps the printed circuit cards can either be moved to new racks in a special machine for electrolytic plating or continue the process with electrolytic plating in special stations in the same machine in which the preceding steps have been performed. The latter case is naturally most economical since the process can be continuously performed. In this case the racks must be constructed so that they can conduct current to the individual objects in the racks. In order to prevent the current to be conducted directly into the bath from the racks and causing damages by undesired plating on the racks, these should be covered with an insulating layer except on spaces where the current is transferred to the objects via suitable connector devices.

Disclosure of the invention

The insulating layer on the racks for holding the objects to be plated consists of plastics. This layer shall resist the chemical influence from the used baths, and in addition possess such surface qualities that depositions of metal thereon in the electroless metallizing bath is prevented. The primary condition is then that the activator (palladium) will not be deposited. Even though the material is chosen with great care it is difficult to prevent the activator from being deposited here and there, for example due to wearing or scratches. Certainly metal will be deposited on these activated sections and each time the racks pass through the electroless metallizing bath the thickness of the plating will increase. Besides, new activating spots will occur during each passing through the activating baths so that sooner or later the whole rack will be plated.

It is true that metal depositions also occurs on the current carrying parts of the racks and connector devices during each cycle in the galvanic bath but this plating is removed after each cycle by reversing the current flow through the contact points of the racks in a special bath. In order to decrease the corrosion on the metal parts exposed to the baths these parts are normally made of titanium which is resistant against the commonly used alkaline plating baths and is not dissolved during the "inverted" electrolyzing. Several other metals and metal alloys which per se could be used in the connector devices, for example acid-proof steel are heavily attacked through this inverted electrolyze (electrolytic stripping) in alkaline baths. If acid baths are used the connecting devices may be made of acid resistant steel or aluminium.

The used electrolytic stripping neither removes the activating plating of palladium nor the part of the electroless plated metal which has no contact with the electrolyze current source since these platings are not affected by the electrolytic bath as such. The metal plating as such can certainly be removed by any of the known etching liquids for the metal in question, for example copper chloride for copper. These etching liquids cannot, however, remove the palladium plating which continues to grow. There is a great risk that traces of palladium can be released in the electroless metallizing bath and form precipitation cores so that the bath is quickly damaged. According to known technique strong acids must be used, for example concentrated nitric acid. Such an acid, however, heavily attacks the titanium connector devices. Besides, environmental problems will arise due to nitrous fumes.

Thus, more particularly the claimed invention relates to a method for chemically and selectively stripping platings comprising palladium and at least one of the metals copper and nickel from a support comprising titanium and a plastics material. The invention is characterized in that the plating is immersed into a bath consisting of an aqueous solution of 20—200 g/l nitric acid, 10—100 g/l hydrogen peroxide, 1—5 moles/l sulphuric acid or phosphoric acid and optionally a hydrogen peroxide stabilizer.

Further the claimed invention relates to a bath for carrying out the claimed method characterized in that it consists of an aqueous solution of 20—200 g/l nitric acid, 10—100 g/l hydrogen peroxide, 1—5 moles/l sulphuric acid or

phosphoric acid and optionally a hydrogen peroxide stabilizer.

DE—A—2532773 discloses baths for the dissolution of metals comprising mineral acid solutions containing nitric acid as well as hydrogen peroxide but the problem to be solved as described in said publication is quite different from the problem to be solved by the claimed invention. Thus the object of DE—A—2532773 is to prevent the formation of nitrous fumes when dissolving metals in nitric acid in general and this object is achieved by adding to the acid solution hydrogen peroxide and optionally a hydrogen peroxide stabilizer. It is, however to be noted that DE—A—2532773 in no way touches the problem to be solved by the claimed invention and due to this it does not disclose or even indicate any bath which can chemically and selectively strip platings comprising palladium and copper or nickel from a support comprising titanium and a plastics material without the titanium being attacked. On the contrary Example 3 of DE—A—2532773 relates to a bath for the very etching of titanium metal and this bath contains hydrochloric acid. Such a bath is very unsuitable for use in the process of the present invention since titanium is attacked in the presence of chloride ions and the copper stripping is dramatically reduced.

With a method according to the invention it is possible to let the rack continuously pass through a number of plating processes without any formation of palladium- and plating metal layers on the insulated surfaces, any attacks on the connector devices and any problems with poisonous fumes. An embodiment according to the invention is characterized as it is shown in the attached claims.

Brief description of drawing

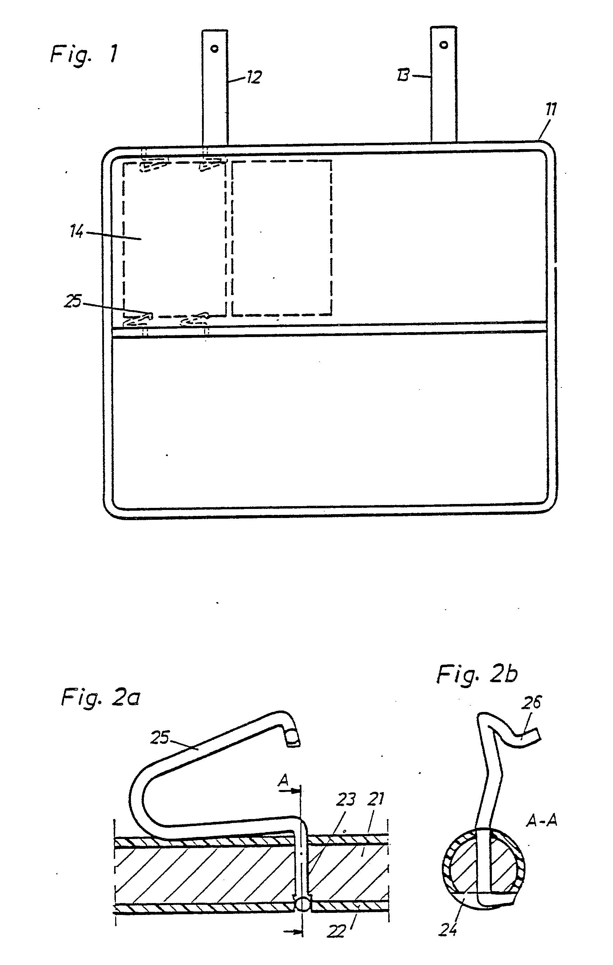

The invention is described more in detail in connection to the attached drawing where Figure 1 shows a rack shaped as a mounting frame and Figure 2a and 2b show two projections, partly in cross section of a connector device.

Mode for carrying out the invention

In Figure 1, 11 designates a frame made from a metal resistant to corrosion preferably titanium. There are suspension- and contact arms 12, 13 attached to the frame and electrically connected with it, by means of which the frames are attached to a conveyor not shown, but known per se. By means of the conveyor the frames are transferred from one bath to another in the metallizing process. In the baths where electrolytical treatment occurs the connector frames 12, 13 are connected to a current source. The frame 11 is coated with an insulating layer 22 outside the metal core 21 as shown in Figures 2a and 2b. The plastic coating shall be resistant to corrosion and possess such surface qualities that deposited by an activator, usually palladium, for the electroless deposition is prevented. A suitable material is flexible PVC or polypropylene.

The frame 11 is provided with appropriately spaced holes 23 and transverse grooves 24 in connection to these holes. In the holes 23 and the grooves 24 there are mounted electrically conducting, elastic clamps 25 which make contact with the metal core 21 of the frame. The objects, for example printed circuits 14, which shall be metallized are suitably attached to the clamps 25 by means of putting the ends 26 of the clamps which are formed as hooks, into suitable holes in the printed circuits 14.

During the metallization the whole frame is submerged into different baths, being used in the chosen process. A great number of such processes with combined electroless and electrolytic plating are known in the literature and are all including three main steps: activation, electroless plating and electrolytic plating. The plated metal is as regards printed circuits usually copper while the activator is palladium.

After the metallization the printed circuit 14 is removed from the frame 11. The parts of the clamps 25 and the frame 21 where metallic parts are exposed to the baths have been covered with a metal plating. In order to prevent this plating from growing in the following metallizing cycles the frames will pass an electrolytic stripping bath.

For copper it can consist of:

10 volume % sulphuric acid

50 g/l  sulphamic acid

100—200 g/l copper sulphamate
traces of chloride for example copper chloride

The electrolysis is performed with the frame as an anode and with a copper cathode. This bath does not affect the spots on the insulated surface 22 of the frames where the activator and copper have been deposited during the electroless process as these spots are not in contact with the current source. In order to prevent these spots from increasing during the following cycles they are preferably removed after each metallizing cycle. This is performed by dipping the frames in an electroless stripping bath after the electrolytic stripping, the bath removing the electroless plating as well as the traces of palladium which have effected the deposition. Such a water based bath comprises at least:

20—200 g/l nitric acid

10—100 g/l hydrogen peroxide

1—5 mol/l sulphuric acid or phosphoric acid

1.0—50 g/l hydrogen peroxide stabilizer, difficult to oxidize, which does not form nitrogen compounds in the special bath for example amino benzoic acid (ABS)

# 0 079 356

The second acid functions as the hydroxonium ion source and anion when dissolving the plated metal and the anion thereof shall be stable in the bath.

The temperature of the bath shall be between 20° and 50°C, preferably 35°—50°C.

The same stripping bath can be used for combined electroless and electrolytic plating of nickel, electrolytic plating of nickel on electroless deposited copper, electrolytically deposited copper on electroless deposited nickel and for combined electroless and electrolytic plating of alloys containing copper and/or nickel, for example bronze, copper, nickel and brass.

Example 1

When metallizing copper laminated printed circuits palladium is used as an activator for the deposition of an electroless copper plating with a thickness of 1 μm. This plating is increased by electrolytically deposited copper up to around 30 μm. After the printed circuits had been removed from the racks, the racks are electrolytically stripped in a bath with the previously designated composition. Thereafter the racks were dipped in an electroless stripping bath containing a water solution of

100 g/l   nitric acid

10 g/l   hydrogen peroxide

3 g/l   amino benzoic acid (ABS)

100 g/l   sulphuric acid

The bath has a temperature of 45°C.
The time of the treatment was 8 minutes.
After the treatment all deposited copper and palladium had been removed. No attacks on the connector devices could be observed.

Example 2

For plating plastics objects the plastics surface is activated with palladium and a thin layer of nickel is deposited from an electroless plating bath known per se. The nickel plating was electrolytically reinforced. After the objects had been removed from the rack an electrolytic stripping took place in a bath with principally the same composition as described above but with the copper salt replaced by a corresponding nickel salt and pH was kept within the limits 2.0—4.5 to avoid gassing. Thereafter the rack was dipped in a bath consisting of

100 g/l   nitric acid

10 g/l   hydrogen peroxide

3 g/l   amino benzoic acid (ABS)

100 g/l   sulphuric acid

The bath had a temperature of 45°C.

The treatment time was 8 minutes.
After the treatment all precipitated nickel and palladium had been removed. No attacks on the connector devices could be observed.

**Claims**

1. A method for chemically and selectively stripping platings including palladium and at least one of the metals copper and nickel from a support comprising titanium and plastics material, characterized in that the plating is submerged into a bath consisting of a water solution of 20—200 g/l nitric acid, 10—100 g/l hydrogen peroxide, 1—5 mol/l sulphuric acid or phosphorous acid and possibly a hydrogen peroxide stabilizer.

2. A method as claimed in claim 1, characterized in that the stabilizer is amino benzoic acid.

3. A method as claimed in claim 1 or 2, characterized in that the bath temperature is 20°—50°C.

4. A bath for carrying out the method according to claim 1, characterized in that it consists of a water solution of 20—200 g/l nitric acid, 10—100 g/l hydrogen peroxide, 1—5 mol/l sulphuric acid or phosphoric acid and a hydrogen peroxide stabilizer.

5. A bath as claimed in claim 4, characterized in that the stabilizer is amino benzoic acid.

**Patentansprüche**

1. Verfahren zum chemischen selektiven Entfernen von Plattierungen, die Palladium, und wenigstens eines der Metalle Kupfer und Nickel einschliessen, von einem Träger, der Titan und Plastikmaterialien umfasst, dadurch gekennzeichnet, dass die Plattierung in ein Bad eingetaucht wird, welches aus einer Wasserlösung aus 20 bis 200 g/l Salpetersäure, 10 bis 100 g/l Wasserstoffperoxid, 1 bis 5 Mol/l Schwefelsäure oder Phosphorsäure und gegebenenfalls einem Wasserstoffperoxidstabilisator besteht.

2. Verfahren gemäss Anspruch 1, dadurch gekennzeichnet, dass der Stabilisator Aminobenzoesäure ist.

3. Verfahren gemäss Anspruch 1 oder 2, dadurch gekennzeichnet, dass die Badtemperatur 20 bis 50°C beträgt.

4. Bad zur Durchführung des Verfahren gemäss Anspruch 1, dadurch gekennzeichnet, dass es aus einer Wasserlösung von 20 bis 200 g/l Salpetersäure, 10 bis 100 g/l Wasserstoffperoxid, 1 bis 5 Mol-%/l Schwefelsäure oder Phosphorsäure und einem Wasserstoffperoxidstabilisator besteht.

5. Bad gemäss Anspruch 4, dadurch gekennzeichnet, dass der Stabilisator Aminobenzoesäure ist.

**Revendications**

1. Procédé pour enlever chimiquement et sélectivement de dépôts comprenant du palladium et au moins l'un des métaux constitués par le cuivre et le nickel, d'un support comprenant du titane et une matière plastique, caractérisé en ce que le dépôt est plongé dans un bain constitué d'une solution aqueuse de 20—200 g/l d'acide nitrique, 10—100 g/l de peroxyde d'hydrogène, 1—5 moles/l d'acide sulfurique ou d'acide phosphorique et, le cas échéant, d'un stabilisant du peroxyde d'hydrogène.

2. Procédé selon la revendication 1, caractérisé en ce que le stabilisant est de l'acide amino-benzoïque.

3. Procédé selon la revendication 1 ou 2, caractérisé en ce que la température de bain est de 20°—50°C.

4. Bain pour la mise en oeuvre du procédé selon la revendication 1, caractérisé en ce qu'il est constitué d'une solution aqueuse de 20—200 g/l d'acide nitrique, 10—100 g/l peroxyde d'hydrogène, 1—5 moles/l d'acide sulfurique ou d'acide phosphorique et d'un stabilisant du peroxyde d'hydrogène.

5. Bain selon la revendication 4, caractérisé en ce que le stabilisant est de l'acide amino-benzoïque.

Fig. 1

Fig. 2a

Fig. 2b